# EUROPEAN PATENT APPLICATION

(11) **EP 2 613 364 A2**
(43) Date of publication of application: **10.07.2013**
(21) Application number: 13150388.0
(22) Date of filing: 07.01.2013
(51) Int. Cl.: H01L 31/048

(54) **Photovoltaic module**

(30) Priority: 06.01.2012 KR 20120002011
(71) Applicant: Samsung Corning Precision Materials Co., Ltd., Gyeongsangbuk-do Gumi-si, 730-735 (KR)
(72) Inventor: Lee, Hoikwan, 336-841 Asan-si ChungCheongNam-Do (KR); Yoon, Kyungmin, 336-841 Asan-si ChungCheongNam-Do (KR); Cho, Seo-Yeong, 336-841 Asan-si ChungCheongNam-Do (KR); Kwon, YoonYoung, 336-841 Asan-si ChungCheongNam-Do (KR); Nam, Jinsu, 336-841 Asan-si ChungCheongNam-Do (KR); Park, Kyungwook, 336-841 Asan-si ChungCheongNam-Do (KR); Choi, Jeayoung, 336-841 Asan-si ChungCheongNam-Do (KR)
(74) Representative: Gulde Hengelhaupt Ziebig & Schneider

(57) **Abstract**

A photovoltaic module for converting light energy into electrical energy. The photovoltaic module has a convex curvature which is exposed outward. The photovoltaic module prevents sagging, which would otherwise occur due to the increased weight caused by an increase in size.

## Description

### CROSS REFERENCE TO RELATED APPLICATION

The present application claims priority from Korean Patent Application Number 10-2012-0002011 filed on January 6, 2012, the entire contents of which application are incorporated herein for all purposes by this reference.

### BACKGROUND OF THE INVENTION

### Field of the Invention

The present invention relates to a photovoltaic module, and more particularly, to a photovoltaic module which prevents sagging, which would otherwise occur due to the increased weight caused by an increase in size.

### Description of Related Art

Recently, as a counter measure to the shortage of energy resources and environmental pollution, the development of photovoltaic modules is underway on a large scale. A photovoltaic module is a key device for photovoltaic power generation that directly converts solar energy into electric energy. While demands for photovoltaic modules are rapidly increasing, the necessity to increase their sizes is also increasing. In addition, in order to cope with increases in weight due to the corresponding size of photovoltaic modules, the importance of having lightweight photovoltaic modules is also sharply increasing.

The cover glass makes up the greatest part of the weight of a photovoltaic module. The weight of the cover glass is decreased by reducing the thickness thereof while maintaining the mechanical strength thereof using tempering technology. Accordingly, the strength of the cover glass, including surface compressive stress or bending stress, has increased while its thickness has decreased. However, as the thickness of the cover glass decreases and its bending stress increases, its flexibility with respect to an external load also increases. In particular, in an area in which a large amount of snow falls, or when a heavy snowfall occurs in winter, the snow load applied to the cover glass abnormally increases. Consequently, although a piece of cover glass having a thickness of 3.2 mm is applied to commercial photovoltaic modules, there are problems in that the frame is dislodged and the photovoltaic cell becomes damaged.

In order to overcome the problems that occur due to this bending property, i.e. sagging, of the cover glass, a piece of cover glass having a thickness of 4 mm was applied to photovoltaic modules. However, this measure works against the goal of having lightweight photovoltaic modules and a thin profile of the cover glass. In addition, "an automatic snow removal device" which automatically removes snow that has accumulated on a photovoltaic module was developed. There is also a case in which a separate support structure "rail" is added to the rear surface of a photovoltaic module in order to prevent the module from sagging. However, these measures also contradict the goal of decreased weight of the photovoltaic modules. The provision of an additional device consequently leads to an increase in the cost of photovoltaic modules.

Therefore, a technology that can prevent the thin cover glass from sagging while satisfying both the large size and lightness of photovoltaic modules is being urgently required.

The information disclosed in the Background of the Invention section is only for the enhancement of understanding of the background of the invention, and should not be taken as an acknowledgment or any form of suggestion that this information forms a prior art that would already be known to a person skilled in the art.

### BRIEF SUMMARY OF THE INVENTION

Various aspects of the present invention provide a photovoltaic module which prevents the sagging, which would otherwise occur due to the increased weight caused by an increase in size.

Also provided is a photovoltaic module which satisfies both the large size and lightweight of photovoltaic modules.

In an aspect of the present invention, provided is a photovoltaic module for converting light energy into electrical energy which has a convex curvature which is exposed outward.

In an embodiment, the photovoltaic module may further include a hexahedron structure having four side surfaces. The four side surfaces include a first pair of opposing side surfaces which has an arc-shaped cross-section and a second pair of opposing side surfaces which has a linear cross-section.

In an embodiment, the first pair of opposing side surfaces may form a pair of short axis surfaces, and the second pair of opposing side surfaces may form a pair of long axis surfaces. The linear length between opposite ends of the pair of long axis surfaces is longer than an arc length between opposite ends of the short axis surfaces.

In addition, the shortest direct distance between the opposite ends of the pair of short axis surfaces may be shorter by 0.25% to 5% (more preferably 0.5% to 3% and still more preferably 1% to 2%) than the arc length between the opposite ends of the pair of short axis surfaces.

In an embodiment, the first pair of opposing side surfaces may form a pair of long axis surfaces, and the second pair of opposing side surfaces may form a pair of short axis surfaces. The linear length between opposite ends of the pair of short axis surfaces is shorter than an arc length between opposite ends of the long axis surfaces.

In addition, the shortest direct distance between the opposite ends of the pair of long axis surfaces may be shorter by 0.25% to 5% (more preferably 0.5% to 3% and still more preferably 1% to 2%) than the arc length between the opposite ends of the pair of long axis surfaces.

In an embodiment, the photovoltaic module may have a tile shape.

In addition, the side surfaces of the photovoltaic module may be fixedly coupled to and supported by a frame, and the inner side surfaces of the frame on which the side surfaces of the photovoltaic module are seated may have a concave round shape.

Preferably, the thickness of the cover glass of the photovoltaic module is uniform. Preferably, the thickness of the cover glass ranges between 0.1 mm and 4 mm, more preferably between 1.0 mm and 3.5 mm and still more preferably between 1.7 mm and 2.5 mm. Preferably a surface area of the cover glass ranges between 0.01 sqm (square meter) and 20 sqm, more preferably between 0.5 sqm and 5 sqm and still more preferably between 1 sqm and 2.5 sqm. Preferably a ratio of the thickness and the surface area of the cover glass ranges between 1 and 50 (mm/sqm), more preferably between 1.5 and 25 and still more preferably between 2 and 20.

According to embodiments of the invention, the overall shape having a curvature makes it possible to prevent sagging, which would otherwise occur in a photovoltaic module having a large size of the related art. It is also possible to prevent the frame from dislodging or a photovoltaic cell from being damaged, which would otherwise be caused by the sagging.

In addition, it is possible to satisfy both the large size and lightweight of the photovoltaic module by preventing sagging when a thin piece of cover glass is applied thereto.

Furthermore, the photovoltaic module of the invention exhibits the same light transmittance as a flat photovoltaic module of the related art. At a predetermined angle of incidence, the photovoltaic module of the invention exhibits better light transmittance than flat photovoltaic module of the related art.

In addition, since the photovoltaic module of the invention has a tile shape unlike the uniform flat shape of the related art, it is possible to improve the aesthetic value of the photovoltaic module as an outdoor structure.

The methods and apparatuses of the present invention have other features and advantages which will be apparent from, or are set forth in greater detail in the accompanying drawings, which are incorporated herein, and in the following Detailed Description of the Invention, which together serve to explain certain principles of the present invention.

### BRIEF DESCRIPTION OF THE DRAWINGS

FIG. 1 is a perspective view schematically showing a photovoltaic module according to an embodiment of the present invention;

FIG. 2 is a perspective view schematically showing a photovoltaic module according to another embodiment of the present invention;

FIG. 3 is a cross-sectional view comparing a photovoltaic module according to an embodiment of the present invention with a photovoltaic module of the related art;

FIG. 4 is a cross-sectional view schematically showing a photovoltaic module according to an embodiment of the present invention which is fastened to a frame;

FIG. 5 is a graph showing variations in the Z-axial displacement of a piece of cover glass which constitutes of a photovoltaic module according to an embodiment of the present invention; and

FIG. 6 is a graph showing the results obtained by measuring the breaking strength of a piece of cover glass constituting a photovoltaic module according to an embodiment of the present invention.

### DETAILED DESCRIPTION OF THE INVENTION

Hereinafter exemplary embodiments of a photovoltaic module according to the invention will be described in detail in conjunction with the accompanying drawings.

In the following description of the present invention, detailed descriptions of known functions and components incorporated herein will be omitted when they may make the subject matter of the present invention unclear.

A photovoltaic module 100 according to an embodiment of the present invention is a photovoltaic power generating device which directly converts light energy, for example, solar energy into electricity. Although not illustrated in detail, the photovoltaic module 100 can be implemented as a structure in which a piece of cover glass, a shock-absorbing member, a photovoltaic cell, a shock-absorbing member and a rear sheet are stacked on each other. Here, the piece of cover glass serves to protect the photovoltaic cell from the external environment including moisture, dust and damage. The shock-absorbing member is a layer which protects the photovoltaic cell from the external environment including moisture penetration, and forms a seal by bonding the photovoltaic cell and the piece of cover glass together. The shock-absorbing member may be made of ethylene vinyl acetate (EVA). In addition, the photovoltaic cell is constituted of, for example, a power generating device which generates a voltage and current from solar light. In an example, the photovoltaic cell may include a transparent conductive oxide electrode, a light-absorbing layer, a back electrode layer and an insulating film. Here, the light-absorbing layer may be made of single crystal or polycrystal silicon, a semiconductor compound which uses copper indium gallium Selenide (CIGS) or cadmium telluride (CdTe), a dye sensitizer in which photosensitive molecular dye which can excite electrons by absorbing visible light are adsorbed on the porous film of nano particles, or amorphous silicon, depending on materials thereof.

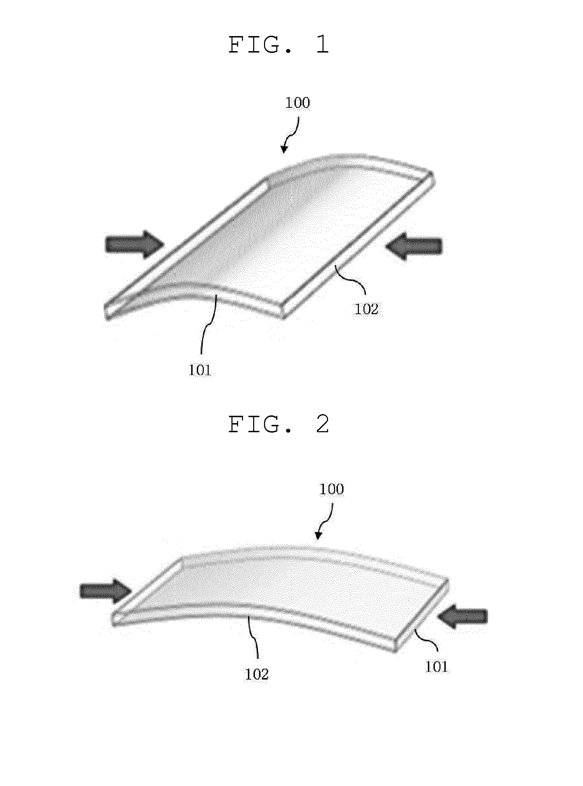

As shown in FIG. 1, the photovoltaic module 100 has a convex curvature which is exposed outward in order to increase anti-deformation characteristic against an external load such as snow, i.e. in order to prevent sagging which would otherwise occur under the external load. As shown in the figure, the photovoltaic module 100 can be configured as a hexahedron which has four side surfaces. Among the four side surfaces, a first pair of opposing side surfaces has an arc-shaped cross-section, and a second pair of opposing side surfaces has a linear cross-section. Specifically, in the photovoltaic module 100 according to this embodiment, the side surfaces include a pair of short axis surfaces 101 which face each other and a pair of long axis surfaces 102 which face each other. Here, the pair of short axis surfaces 101 is defined as a pair of surfaces of which the linear length between the opposite ends is shorter than the arc length between the opposite ends of the pair of long axis surfaces 102. According to an embodiment of the present invention, the pair of short axis surfaces 101 is arc-shaped, and the pair of long axis surfaces 102 is linear-shaped. Since the pair of short axis surfaces 101 which face each other is arc-shaped, the surface of the photovoltaic module 100 is exposed outward with a convex curvature.

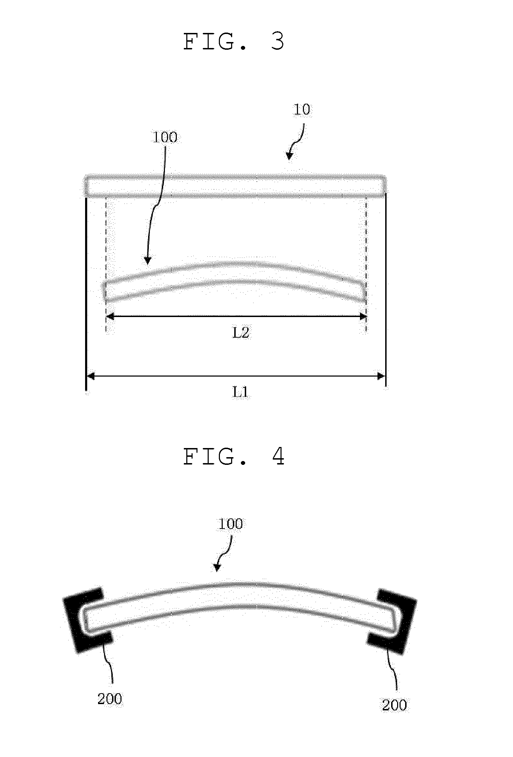

Here, the degree of the convex curvature must be controlled to the extent that does not damage the transmittance of solar light while increasing the strength of the photovoltaic module 100 against an external load. The degree of the convex curvature can be calculated by comparison with a flat photovoltaic module (see FIG. 3). That is, in an embodiment of the present invention, it is preferred that the shortest direct distance L2 between the opposite ends of the pair of short axis surfaces 101 which forms the convex curvature in the photovoltaic module 100 be shorter by 1% to 2% than the arc length L1 between the opposite ends of the pair of short axis surfaces 101. The critical meaning thereof will be described in detail later.

As shown in FIG. 2, in the photovoltaic module 100 according to another embodiment of the present invention, a pair of long axis surfaces 102 is arc-shaped, whereas a pair of short axis surfaces 102 is linear-shaped. As the pair of long axis surfaces 102 which face each other is arc-shaped, the surface of the photovoltaic module 100 which is exposed outward forms a convex curvature.

Like the former embodiment of the present invention, according to this embodiment of the present invention, the degree of the convex curvature of the photovoltaic module 100 must be controlled to the extent that does not damage the transmittance of solar light while increasing the strength of the photovoltaic module 100 against an external load. Here, the degree of the convex curvature can be calculated by comparison with a flat photovoltaic module. In this embodiment of the present invention, it is preferred that the shortest direct distance between the opposite ends of the pair of long axis surfaces 102 which forms the convex curvature in the photovoltaic module 100 be shorter by 1% to 2% than the arc length between the opposite ends of the pair of long axis surfaces 102.

Accordingly, the photovoltaic module 100 of the present invention is configured such that the short axis surfaces 101 or the long axis surfaces 102 are arc-shaped, thereby defining the surface of the photovoltaic module 100 which is exposed outward as a convex curvature. Here, the surface of the photovoltaic module 100 opposite the convex curvature defines a convex curvature, such that the photovoltaic module 100 generally has a tile shape. When the photovoltaic module 100 has the tile shape in this fashion, the photovoltaic module 100 which is disposed as an outdoor structure can improve the aesthetic value of a building.

In order to impart the arc shape to the pair of short axis surfaces or the pair of long axis surfaces 102 of the photovoltaic module 100, the above-described components of the photovoltaic module 100 are laminated. Afterwards, the same pressure can be applied in the central direction from both sides of the pair of short axis surfaces 101 or the pair of long axis surfaces 102 so that the photovoltaic module 100 is curved, thereby forming a convex curvature.

The curved photovoltaic module 100 can return to the flat shape due to its resilience. Therefore, as shown in FIG. 4, a frame 200 which holds and supports the side surfaces of the photovoltaic module 100 is disposed on a floor on which the photovoltaic module 100 is disposed such that the photovoltaic module 100 is inclined upward. When the frame 200 is disposed in this fashion, the photovoltaic module 100 can maintain its shape when fixed to the frame 200. It is therefore possible to prevent the photovoltaic module 100 from returning to a flat shape. Here, pieces of transparent cover glass are disposed on the upper and lower surfaces of the photovoltaic module 100. When the side surfaces of the photovoltaic module 100 are coupled with the frame 200, peripheries of the cover glass may be damaged or fractured during the assembling process. In the present invention, in order to prevent this problem, the inner sections of the frame 200 in which the side surfaces of the photovoltaic module 100 are to be seated may be rounded so as to have a concave shape. In addition, in order to strengthen the coupling between the photovoltaic module 100 and the frame 200, a sealing material may be packed in the inner sections of the frame 200 in which the photovoltaic module 100 is seated.

A description will be given below of the characteristics of the photovoltaic module according to the present invention.

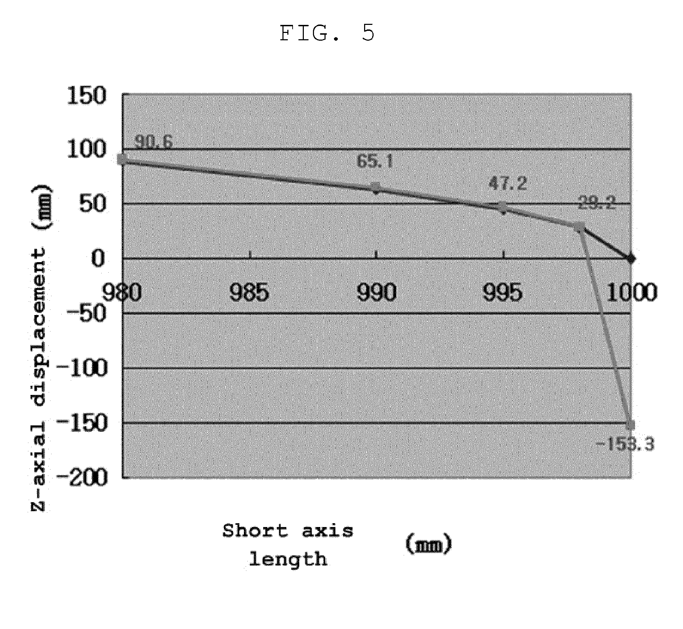

In order to evaluate the characteristics of the photovoltaic module 100 according to the present invention, the cover glass among the components of the photovoltaic module 100 was subjected to simulation. Specifically, a piece of glass which is not tempered was imparted with a convex curvature. Here, the glass had an area of 1600 mm X 1000 mm and a thickness of 2 mm. After that, a load of 1000 Pa was applied to the entire area of the glass. The amount of sagging (Z-axial displacement) and maximum principal stress applied to the glass were measured. The results are presented FIG. 5 and Table 1 below, in comparison with those of flat glass. Here, the convex curvature of the glass was formed by decreasing the length of the glass in the short axis direction to 980 mm (by about 2 %).

**Table 1**

| | | Flat glass | Curved glass |
|---|---|---|---|
| Z-axial displacement | Initial state (mm) | 0 | +96.6 |
| | After load applied (mm) | -153.3 | +90.6 |
| | Maximum principal stress (MPa) | 129.4 | 70.9 |

Referring to Table 1 above, because it is assumed that a distribution load of 1000 Pa shall be applied to the entire area of the glass, it is appreciated that the curved glass was deformed in the direction in which the Z-axial displacement increased. When the maximum principal stress of a piece of glass exceeds its breaking stress of 120 MPa, the glass breaks. It is appreciated that the maximum principal stress of the flat glass exceeds this value and the maximum principal stress of the curved glass is 70.9 MPa. Therefore, there is little possibility that the curved glass will break.

In addition, referring to the graph in FIG. 5, it is appreciated that, when the short axis length of the cover glass was decreased (blue), downward sagging did not occur under an external load. It is therefore possible to prevent the cover glass from dislodging from the frame 200 and the photovoltaic cell from being damaged, which would otherwise be caused by the sagging. In contrast, as for the traditional flat glass (pink), it is appreciated that the glass was greatly curved downward when an external load was applied.

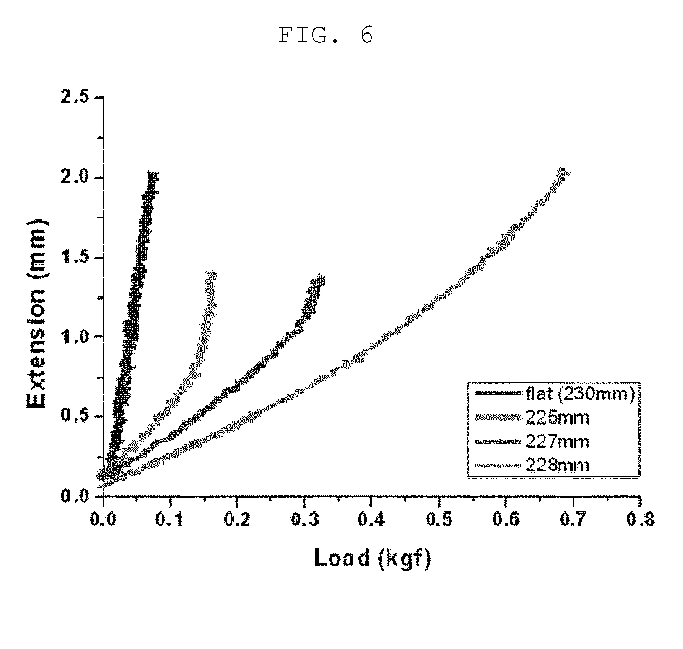

FIG. 6 is a graph showing the results obtained by measuring the breaking strength of a piece of cover glass constituting a photovoltaic module according to an embodiment of the present invention. For this, a piece of glass having an area of 230 mm X 110 mm and a thickness of 0.4 mm was prepared, and a convex curvature was formed by reducing the long axis length of the glass. Afterwards, the breaking strength of the pieces of glass was measured.

Referring to the graph of FIG. 6 which represents Z-axial displacements in pieces of glass when a load of 1 N (0.1 kgf) was applied thereto, the traditional glass without a curvature exhibited sagging of about 2.5 mm or more. In contrast, it is appreciated that the curved glass having a long axis length of 225 mm, which was decreased by 5 mm, exhibited a displacement of only 0.25 mm, which is about 10% of the displacement of the traditional glass. Based on these results, it is appreciated that the degree of sagging of the curved glass with respect to an external load is significantly lower than that of the traditional flat glass.

Through the simulation and experiments as above, it can be understood that the glass having a convex curvature which is exposed outward (curved glass) exhibits excellent mechanical strength to an external load, i.e. deformation resistance property, which is superior to that of the traditional flat glass. It can also be appreciated that the sagging occurs less when the degree of a convex curvature increases.

In addition, the influence of the curvature over the light transmittance of the cover glass was determined, and the range of the curvature that is applicable to the actual photovoltaic module 100 was set.

For this, light transmittances were compared via simulation by setting the angle of glass to a light source in the range from 0° to 90°. The results are presented in Table 2 below. Here, a piece of flat glass had an area of 1600 mm X 1000 mm and a thickness of 2 mm, and pieces of curved glass were prepared by forming a curvature on the flat glass by decreasing the short axis length by 1 % (990 mm) and 2 % (980 mm).

**Table 2**

| Angle of incidence | Light transmittance (W) | | |
|---|---|---|---|
| | 980mm (curved glass) | 990 mm (curved glass) | 1000 mm (flat glass) |
| 0 | 57.4 | 57.983 | 58.499 |
| 10° | 56.512 | 57.099 | 57.61 |
| 20° | 53.827 | 54.449 | 54.941 |
| 30° | 49.4 | 50.044 | 50.505 |
| 40° | 43.168 | 43.828 | 44.281 |
| 50° | 35.209 | 35.804 | 36.207 |
| 60° | 25.778 | 26.179 | 26.286 |
| 70° | 16.106 | 15.682 | 15.338 |
| 80° | 8.092 | 6.6557 | 4.7652 |
| 89° | 1.855 | 1.3292 | 0.07 |
| 90° | 1.251 | 0.8832 | 0 |

Referring to Table 2 above, when the curvatures were formed by decreasing the short axis length of the glass by 1 % and 2 %, the light transmittances of the pieces of glass were equal to those of the traditional flat glass. It is also appreciated that, when the angle approaches 90°, the light transmittance became greater than that of the flat glass.

The foregoing descriptions of specific exemplary embodiments of the present invention have been presented with respect to the certain embodiments and drawings. They are not intended to be exhaustive or to limit the present invention to the precise forms disclosed, and obviously many modifications and variations are possible for a person having ordinary skill in the art in light of the above teachings.

It is intended therefore that the scope of the present invention not be limited to the foregoing embodiments, but be defined by the Claims appended hereto and their equivalents.

## Claims

1. A photovoltaic module (100) adapted for converting light energy into electrical energy, comprising a convex curvature which is exposed outward.

2. The photovoltaic module of claim 1, a cover glass of the photovoltaic module (100) comprises the convex curvature which is exposed outward.

3. The photovoltaic module of any of the preceding claims, comprising a hexahedron structure having four side surfaces (101, 102), wherein the four side surfaces (101, 102) include a first pair of opposing side surfaces (Fig. 1, 101, Fig. 2, 102) which has an arc-shaped cross-section and a second pair of opposing side surfaces (Fig. 1, 102, Fig. 2, 101) which has a linear cross-section.

4. The photovoltaic module of claim 3, wherein the first pair of opposing side surfaces (Fig. 1, 101) forms a pair of short axis surfaces, and the second pair of opposing side surfaces (Fig. 1, 102) forms a pair of long axis surfaces, a linear length between opposite ends of the pair of long axis surfaces (Fig. 1, 102) being longer than an arc length between opposite ends of the short axis surfaces (Fig. 1, 101).

5. The photovoltaic module of claim 4, wherein a shortest direct distance (Fig. 3, L2) between the opposite ends of the pair of short axis surfaces (Fig. 1, 101) is shorter by 1% to 2% than the arc length (Fig. 3, L1) between the opposite ends of the pair of short axis surfaces (Fig. 1, 101).

6. The photovoltaic module of claim 4, wherein the first pair of opposing side surfaces (Fig. 2, 102) forms a pair of long axis surfaces, and the second pair of opposing side surfaces forms a pair of short axis surfaces (Fig. 2, 101), a linear length between opposite ends of the pair of short axis surfaces (Fig. 2, 101) being shorter than an arc length between opposite ends of the long axis surfaces (Fig. 2, 102).

7. The photovoltaic module of claim 6, wherein a shortest direct distance (Fig. 3, L2) between the opposite ends of the pair of long axis surfaces (Fig. 2, 102) is shorter by 1% to 2% than the arc length (Fig. 3, L1) between the opposite ends of the pair of long axis surfaces (Fig. 2, 102).

8. The photovoltaic module of any one of claims 2 to 7, having a tile shape.

9. The photovoltaic module of any one of claims 2 to 8, wherein
the side surfaces (101, 102) of the photovoltaic module (100) are fixedly coupled to and supported by a frame (200), and
inner side surfaces of the frame (200) on which the side surfaces (101, 102) of the photovoltaic module (100) are seated have a concave round shape.

10. The photovoltaic module of any of the preceding claims, wherein photovoltaic module (100) is formed as a structure in which a piece of cover glass, a photovoltaic cell and a rear sheet are stacked on each other.

11. The photovoltaic module of claim 10, wherein a shock-absorbing member is formed between the cover glass and the photovoltaic cell.

12. The photovoltaic module of any one of claims 10 to 11, wherein a shock-absorbing member is formed between the photovoltaic cell and the rear sheet.

13. The photovoltaic module of any one of claims 10 to 12, wherein a curvature of the cover glass is uniform along a direction of the arc-shaped cross-section of the first pair of opposing side surfaces (101).
